# EUROPÄISCHE PATENTANMELDUNG

(11) **EP 0 735 703 A2**
(43) Veröffentlichungstag der Anmeldung: **02.10.1996**
(21) Anmeldenummer: 96103342.0
(22) Anmeldetag: 04.03.1996
(51) Int. Cl.: H04B 7/26

(54) **Automatische Bursterkennung bei Vielfachzugriffsverfahren**

(30) Priorität: 28.03.1995 DE 19511403
(71) Anmelder: SIEMENS AKTIENGESELLSCHAFT, 80333 München (DE)
(72) Erfinder: Bolze, Thomas, Dr., 80804 München (DE); Neidlinger, Stephan, Dr.-Ing., 80807 München (DE)

(57) **Zusammenfassung**

Zur Bursterkennung wird in der Regel dem auszusendenden Burst eine Präambel vorangestellt, die empfangsseitig eine Takterzeugung und eine Amplitudenregelung vor dem Empfang der eigentlichen Nutzdaten ermöglicht. Damit die Taktrückgewinnung möglichst schnell erfolgt, muß außerdem ein Übertragungscode mit hohem Taktanteil verwendet werden. Erfindungsgemäß wird nun vor der Aussendung der gegebenenfalls verkürzten Präambel ein Pilotsignal hoher Amplitude ausgesendet, das empfangsseitig mittels eines Bandpaßfilters und eines Schwellenwertdetektors die leichte Erzeugung eines Steuersignals zur Aktivierung von Taktrückgewinnung und Amplitudenregelung ermöglicht.

## Beschreibung

Die Erfindung betrifft ein Verfahren entsprechend dem Oberbegriff des Anspruchs 1 sowie eine Anordnung zur Durchführung des Verfahrens.

Bei Punkt zu Multipunkt-Übertragungsverfahren, wie beispielsweise passiven optischen Netzen, Koaxialkabelnetzen, Funksystemen mit Rückkanal oder bei Satellitenverbindungen kommunizieren mehrere Teilnehmer mit einer Zentrale. Anstelle eines zeitkontinuierlichen Datenstroms werden dabei von den Teilnehmern allgemein als Bursts bezeichnete Blöcke von Nutzdaten im sogenannten zeitvielfachzugriff - TDMA -gesendet. Diese Datenblöcke sind nicht exakt zueinander synchronisiert und treffen im Empfänger nach unterschiedlicher Laufzeit mit unterschiedlicher Signalamplitude Taktphase ein. Der Empfänger muß daher zu Beginn eines jeden derartigen Datenblocks den Takt für diesen Block rasch zurückgewinnen und außerdem die Signalamplitude mit einer automatischen Verstärkerschaltung regeln oder den Gleichstromanteil des Signals mit einem Hochpaß schnell abbauen. Für eine schnelle Taktrückgewinnung werden die Datenblöcke bisher nach einem Code gebildet, der wie beispielsweise der CMI-Code reichlich Taktinformation enthält. Vor den eigentlichen Nutzdaten wird dazu eine nur zur Steuerung dienende Präambel gesendet, die typischerweise 10 bis 40 Bit umfaßt und hauptsächlich der empfangsseitigen Taktgewinnung sowie zur Einmessung dient. Da insbesondere beim CMI-Code der untere Frequenzbereich unbenutzt bleibt, können die beim Empfang unterschiedlicher Burstamplituden entstehenden Gleichstromanteile durch einen Hochpaß abgebaut werden. Nachteilig bei dieser Lösung ist, daß für eine sichere Taktrückgewinnung, die ja Voraussetzung für den korrekten Empfang der Nutzdaten ist, eine relativ lange Präambel ausgesendet werden muß, die die Übertragungskapazität für Nutzdaten verringert. Durch den verwendeten CMI-Code verdoppelt sich außerdem die Schrittgeschwindigkeit und die Signalbandbreite, wodurch sich die Empfängerempfindlichkeit und bei begrenzter zur Verfügung stehender Bandbreite die Zahl der Nutzsignale verringert und die Signalverarbeitungsgeschwindigkeit verdoppelt.

Die Aufgabe der Erfindung besteht also darin, ein Verfahren der eingangs erwähnten Art so weiterzubilden, das mit vergleichsweise kurzen Präambeln auskommt und den CMI-Code nicht benötigt.

Erfindungsgemäß wird die Aufgabe durch ein Verfahren der eingangs erwähnten Art gelöst, das durch die Merkmale des Kennzeichens des Anspruchs 1 weitergebildet ist. Der Vorteil des erfindungsgemäßen Verfahrens liegt darin, daß mit geringem Aufwand eine Möglichkeit auch zur Übertragung von Signalen in einem NRZ-Code geschaffen wurde, bevorzugte Weiterbildungen des erfindungsgemäßen Verfahrens sind in den Ansprüchen 2 bis 4 beschrieben. Eine mit handelsüblichen Bauteilen leicht aufbaubare Anordnung zur Durchführung des erfindungsgemäßen Verfahrens ist im Anspruch 5 beschrieben.

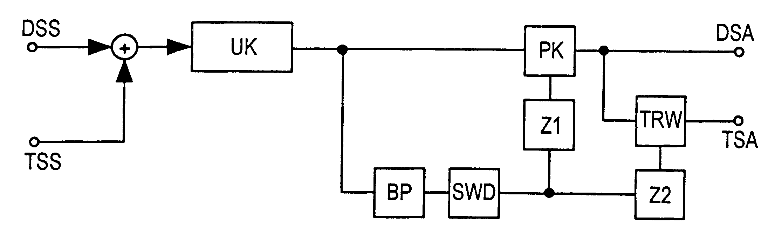

Die Erfindung soll im folgenden anhand eines in der Zeichnung dargestellten Ausführungsbeispiels für eine Anordnung zur Durchführung des Verfahrens näher erläutert werden. Die einzige Figur Fig. 1 zeigt dabei einen Ausschnitt aus einem Punkt-zu-Multipunkt-Netz, bei dem aus dem sendeseitig zu übertragenden Datensignal DSS und einem dazugehörigen Taktsignal TSS durch Modulo-2-Addition ein Übertragungssignal gebildet wird, das über einen Übertragungskanal UK, der empfangsseitig übertragen wird. An den Ausgang des Übertragungskanals UK kann ein Verstärker angeschlossen sein, an dessen Ausgang ein Eingang einer Anordnung PK zur Pegelkontrolle und Pegeleinstellung sowie ein Bandpaßfilter BP angeschlossen sind. Mit dem Ausgang des Bandpaßfilters sind über einen Schwellenwertdetektor SWD die Eingänge eines ersten und eines zweiten Zählers Z1, Z2 angeschlossen. Der Ausgang des ersten Zählers Z1 ist mit einem Steuereingang der Anordnung PK zur Pegelkontrolle verbunden, der Ausgang des zweiten Zählers Z2 ist mit einem Steuersignaleingang einer Anordnung TRW zur Taktrückgewinnung verbunden. Der Ausgang der Anordnung PK zur Pegelkontrolle ist mit einem Signaleingang der Anordnung T (TRW) zur Taktrückgewinnung sowie mit dem Datensignalausgang verbunden, der Ausgang der Anordnung TRW ist mit dem Taktsignalausgang TSA verbunden.

Zur Erläuterung der Funktion der beschriebenen Anordnung sei von einem 5 Bitperioden andauernden Pilotton ausgegangen, dessen Frequenz der Taktfrequenz der zu übertragenden digitalen Nutzsignale entspricht und der vor einer von 40 auf 20 Bit verkürzten Präambel ausgesendet wird. Da eine Störung des Datenempfangs durch die zeitliche Trennung von Pilotsignal und Datensignal ausgeschlossen ist, kann das Pilotsignal mit großer Amplitude ausgesendet werden, so daß nur geringe Anforderungen an die Güte des empfangsseitigen Bandpaßfilters BP gestellt werden müssen und dadurch ein schnelles Einschwingen des gefilterten Signals gewährleistet ist. Dieses mittels Bandpaß gefilterte Signal wird mit einem nachgeschalteten Schwellenwertdetektor SWD in ein Binärsignal umgewandelt, dessen logische Eins-Impulse in dem ersten und zweiten Zähler Z1, Z2 gezählt werden. Nach Erreichen der vorgewählten Endstellung geben diese Zähler jeweils ein Schaltsignal an den Steuersignaleingang der Anordnung PK zur Pegelkontrolle sowie an den Steuersignaleingang der Anordnung TRW zur Taktrückgewinnung ab. Durch diese Schaltsignale werden beide Anordnungen aktiviert, wobei durch die Wahl der Zählerendstellung sichergestellt wird, daß die Anordnung PK zur Pegelkontrolle vor der Anordnung TRW zur Taktrückgewinnung für die Dauer der Präambel aktiviert wird.

Zur sicheren Erkennung des Pilotsignals und damit des Burstanfangs hat es sich als zweckmäßig erwiesen, auch am Burstende ein vergleichsweise kurzes Pilotsignal zu übertragen. Dies bringt zusätzliche Vorteile bei der Einmessung des Systems, da durch die wiederum aktivierte Anordnung PK zur Pegelkontrolle der verbliebene Gleichstromanteil schnell abgebaut wird.

## Patentansprüche

1. Verfahren zur automatischen Bursterkennung bei Vielfachzugriffsverfahren vorzugsweise in TDM/TDMA-Systemen, bei denen vor dem zu übertragenden Nutzdatenblock eine aus mehreren Bit bestehende Präambel übertragen wird,
**dadurch gekennzeichnet,**
daß vor der Aussendung der Präambel für vergleichsweise kurze Zeit ein Pilotsignal mit vergleichsweise hoher Amplitude ausgesendet wird, dessen Frequenz sich bei einer Nullstelle des für die Nutzsignalübertragung verwendeten Codes oder außerhalb des Signalspektrums des Nutzsignals befindet, daß aus dem übertragenen Pilotsignal empfangsseitig ein Steuersignal erzeugt wird und daß dieses Steuersignal die empfangsseitige Taktrückgewinnungsschaltung und/oder die empfangsseitige Pegelregelung aktiviert.

2. Verfahren nach Patentanspruch 1,
**dadurch gekennzeichnet,**
daß die Frequenz des Pilotsignals der Taktfrequenz der zu übertragenden digitale Nutzsignale entspricht.

3. Verfahren nach Patentanspruch 1,
**dadurch gekennzeichnet,**
daß die Dauer des Pilottones etwa 5 Bitperioden des zu übertragenden digitalen Nutzsignals entspricht.

4. Verfahren nach Patentansprüchen 1,2 oder 3,
**dadurch gekennzeichnet,**
daß auch am Burstende ein Pilotsignal übertragen wird.

5. Anordnung zur Durchführung eines Verfahrens nach den Patentansprüchen 1 bis 4,
**dadurch gekennzeichnet,**
daß empfangsseitig mit einem Ausgang eines, eine Übertragungsleitung abschließenden Empfängers, ggf. nach Zwischenschaltung eines Verstärkers ein Eingang eines Bandpaßfilters (BP) und ein Eingang einer Anordnung(PK) zur Pegelkontrolle verbunden sind,
daß mit einem Ausgang des Bandpaßfilters (BP) über einen Schwellenwertdetektor (SWD) die Eingänge eines ersten und eines zweiten Zählers (Z1, Z2) verbunden sind,
daß ein Ausgang des ersten Zählers(Z1) mit einem Steuersignaleingang der Anordnung (PK) zur Pegelkontrolle verbunden ist,
daß ein Ausgang des zweiten Zählers(Z2) mit einem Steuersignaleingang der Anordnung (TRW) zur Taktrückgewinnung verbunden ist,
daß mit einem Ausgang der Anordnung (PK) zur Pegelkontrolle ein Signaleingang der Anordnung (TRW) zur Taktrückgewinnung und ein Datensignalausgang (DSA) verbunden sind und daß mit dem Ausgang der Anordnung zur Taktrückgewinnung(TRW) ein Taktsignalausgang (TSA) verbunden ist.
